# DEMANDE DE BREVET EUROPEEN

(11) **EP 1 840 371 A1**
(43) Date de publication de la demande: **03.10.2007**
(21) Numéro de dépôt: 07300878.1
(22) Date de dépôt: 19.03.2007
(51) Int. Cl.: F02P 17/00, G01R 31/06

(54) **Dispositif de diagnostic d'une bobine d'allumage pour moteur à combustion interne**

(30) Priorité: 30.03.2006 FR 0651123
(71) Demandeur: Renault SAS, 92100 Boulogne Billancourt (FR)
(72) Inventeur: STAUNER, Daniel, 91510, LARDY (FR)

(57) **Abrégé**

Dispositif (50) de diagnostic d'une bobine d'allumage (21), comportant un enroulement primaire et un enroulement secondaire, pour moteur à combustion interne, destiné à la réalisation d'un test de la bobine indépendamment du moteur à combustion interne, le dispositif comportant :
- des moyens de connexion électrique (8,10) dudit dispositif à une source d'alimentation en tension
- des moyens de connexion du dispositif (50) à la bobine (21) à tester,
- des moyens de mesure de grandeurs représentatives de l'état de fonctionnement de la bobine d'allumage à tester,
- des moyens de contrôle et de commande du test
- des moyens de visualisation (16,18) du résultat du diagnostic

caractérisé en qu'il comporte une sonde (6) apte à être insérée dans un évidement (21 b) aménagé dans la partie isolante de la bobine à tester pour d'une part établir un contact électrique entre le secondaire de la bobine à tester et une résistance de la sonde et, d'autre part, maintenir en position la bobine à tester lors d'un test.

## Description

La présente invention concerne un dispositif de diagnostic d'un organe composant d'un moteur à combustion interne. Elle concerne plus particulièrement la détection d'un disfonctionnement d'une bobine d'allumage indépendamment d'un tel moteur.

Des dispositifs de test du bon fonctionnement d'une bobine d'allumage pour moteur à combustion interne ont déjà été proposés. Ainsi, la publication US2005/0200361 décrit un dispositif de test de bobine d'allumage indépendamment d'un moteur à combustion interne comportant un carter de réception en deux parties de la bobine à tester et une bougie d'allumage, la forme et les dimensions de ce carter correspondent à celles d'un puits de bougie d'allumage d'un moteur à combustion interne ou sont ajustables aux dimensions d'un tel puits.

Pour réaliser un test, l'opérateur doit installer la bougie à tester dans le carter de test et doit adapter les dimensions du carter de test standard aux dimensions de la bobine à tester.

Ce dispositif convient particulièrement aux tests de bobine d'allumage en laboratoire et est difficilement transportable car il se rapproche des conditions d'utilisation de la bobine au sein d'un moteur à combustion interne en fonctionnement.

Ce dispositif ne permet pas de tester simplement et rapidement une bobine d'allumage. En outre, ce dispositif de test comporte une bougie de test supplémentaire, ce qui en augmente le coût et la difficulté d'entretien.

La présente invention se propose, entre autres buts, de résoudre les inconvénients liés à cet art antérieur en fournissant un dispositif de test d'une bobine d'allumage particulièrement simple d'utilisation.

Dans ce but l'invention propose un dispositif de diagnostic d'une bobine d'allumage, comportant un enroulement primaire et un enroulement secondaire, pour moteur à combustion interne, destiné à la réalisation d'un test de la bobine indépendamment du moteur à combustion interne, le dispositif comportant :
- des moyens de connexion électrique dudit dispositif à une source d'alimentation en tension
- des moyens de connexion dudit dispositif à la bobine à tester,
- des moyens de mesure de grandeurs représentatives de l'état de fonctionnement de la bobine d'allumage à tester,
- des moyens de contrôle et de commande du test
- des moyens de visualisation du résultat du diagnostic
caractérisé en qu'il comporte une sonde apte à être insérée dans un évidement aménagé dans la partie isolante de la bobine à tester pour d'une part établir un contact électrique entre le secondaire de la bobine à tester et une résistance de la sonde et, d'autre part maintenir en position la bobine à tester lors d'un test.

Un des avantages du dispositif selon l'invention est qu'il permet de réaliser le test d'une bobine d'allumage de moteur à combustion interne sans nécessité d'introduire la bobine à tester dans un carter simulant un puits de bougie d'allumage. En outre le dispositif comporte, dans un seul boîtier, l'ensemble des éléments de mesure et de diagnostique nécessaire à la réalisation d'un test, et il peut être transporté facilement. De plus la déconnexion de la bobine à tester du dispositif de test est particulièrement simple.

Le dispositif selon l'invention comporte un boîtier de protection de faible encombrement destiné au transport du dispositif.

Selon un aspect de l'invention la sonde est solidaire du boîtier de protection.

Selon un autre aspect de l'invention, une partie de la sonde est externe au boîtier de test.

Avantageusement, la sonde est de forme sensiblement cylindrique de diamètre proche de celui d'une bougie d'allumage et elle comporte une borne de connexion, à son extrémité extérieure au boîtier, pour permettre la connexion du secondaire de la bobine à la résistance de la sonde.

Le dispositif selon l'invention comporte intégrée au boîtier une unité électronique de commande préprogrammée et apte à réaliser successivement :
- la mise sous tension du primaire de la bobine ,
- la mesure de la valeur d'une tension représentative du courant traversant le primaire de la bobine,
- la comparaison entre cette valeur mesurée et une valeur de tension préenregistrée pour fournir le diagnostic de l'état de fonctionnement de la bobine à tester
- la mesure de la valeur d'une tension représentative de la haute tension générée au secondaire de la bobine et,
- la comparaison entre cette valeur mesurée et une valeur de tension préenregistrée pour fournir le diagnostic de l'état de fonctionnement de la bobine à tester.

Afin de mesurer la tension représentative du courant traversant le primaire de la bobine à tester, une des entrées de l'unité électronique de commande est connectée entre la sortie du primaire de la bobine d'allumage à tester et une résistance qui est connectée entre la sortie du primaire et la masse.

Pour mesurer la valeur de la tension représentative de la haute tension générée par la bobine lors du diagnostic, une autre des entrées de l'unité de commande électronique est connectée au point milieu d'un pont diviseur de tension composé de la sonde résistive et d'une résistance, le pont diviseur de tension étant lui même connecté au secondaire de la bobine.

Selon une autre caractéristique de l'invention la sonde est résistive.

Le dispositif selon l'invention comporte au moins une diode électroluminescente et /ou au moins un afficheur pour l'affichage du ou des résultats du diagnostic de la bobine tester.

D'autres avantages et caractéristiques de la présente invention apparaîtront à l'examen de la description détaillée d'un mode de réalisation, nullement limitatif, et des dessins annexés, sur lesquels :
- la figure 1 est une vue schématique d'un circuit d'allumage classique d'un moteur à combustion interne.
- la figure 2 est une vue schématique externe du boîtier de test connecté à la bobine d'allumage à tester.
- la figure 3 est un schéma électronique du dispositif selon l'invention connecté à la bobine à tester.

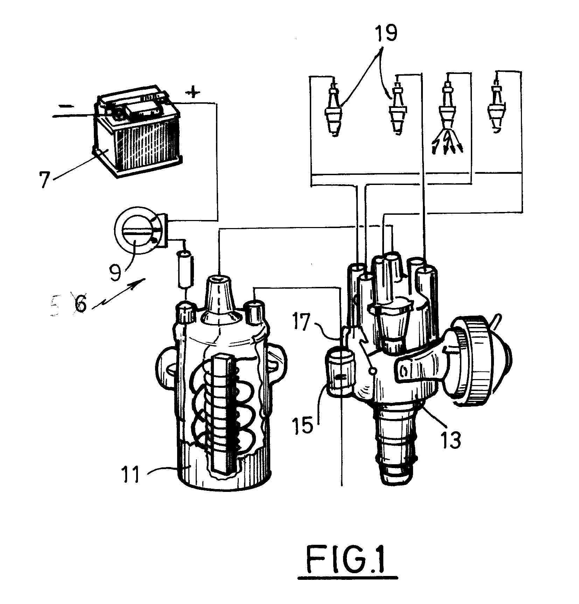

On se reporte à présent à la figure 1. Un circuit d'allumage conventionnel 5 comporte une bobine 11 dont l'enroulement primaire est relié en série avec une batterie d'accumulateurs 7 et est couplé électromagnétiquement, pour constituer un transformateur de tension, à un enroulement secondaire placé dans un circuit haute tension comportant un entrefer d'éclatement appartenant à une bougie 19. Dans ce système d'allumage 5, les coupures intermittentes sont réalisées par un rupteur 17 qui est interposé dans la ligne électrique de retour du bobinage à la masse. L'ouverture et la fermeture du rupteur 17 sont provoquées par une unité électronique de commande. Le rupteur 17 est un élément d'un allumeur 13. Au moment où le circuit primaire se ferme, le courant s'établit progressivement et lorsque le circuit primaire s'ouvre, ce courant se trouve alors dérivé vers le condensateur 15 branché aux bornes du rupteur 17. Le condensateur se charge de courant de self puis se décharge aussitôt. La variation brutale du flux dans le circuit primaire provoque la formation d'un courant haute tension dans l'enroulement secondaire puis ce courant est distribué vers l'une des bougies 19.

Le dispositif selon l'invention permet de détecter un mauvais fonctionnement d'une bobine assurant les mêmes fonctions que celle présentée ci-dessus.

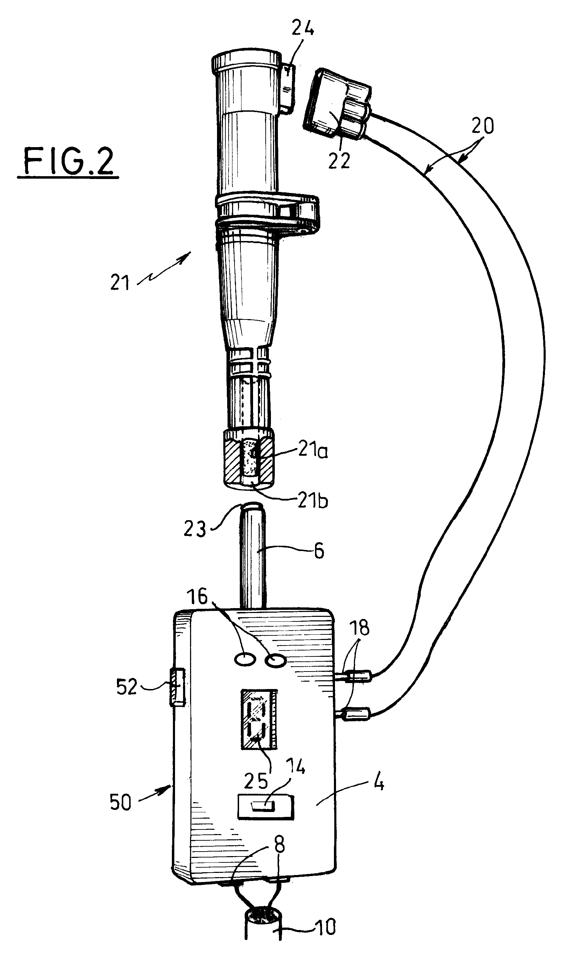

Comme on peut le voir à la figure 2 le dispositif 50 selon l'invention comporte un boîtier 4 de test et de protection de forme parallélépipédique. Ce boîtier de faible encombrement (dans ce mode de réalisation de l'ordre de 114 x 63 x 29 mm) et de faible masse, (dans ce mode de réalisation de l'ordre de 300g) autorise le transport et la manipulation aisés du dispositif selon l'invention. Le dispositif 50 est muni pour son alimentation en tension de plots 8 et de câbles électriques 10 pouvant par exemple être connectés à une batterie d'accumulateur de véhicule automobile. Le dispositif 50 comporte en outre une sonde 6 solidaire du boîtier 4 pour la connexion ou raccordement électrique du boîtier au secondaire de la bobine 21 à tester, un interrupteur de commande du lancement de test 14, deux diodes électroluminescentes (D.E.L.) 16 et un à afficheur 25 à sept segments destinés à l'affichage du résultat d'un test. Le dispositif de test 50 est aussi connecté au primaire de la bobine 21 à tester grâce aux connecteurs 18 du boîtier de test qui sont reliés à des câbles électriques 20 eux mêmes connectés à un connecteur électrique 22 apte à coopérer avec le connecteur d'alimentation 24 de la bobine 21 à tester. Le dispositif 50 selon l'invention dispose également d'un connecteur 52 d'entrée/sortie de données et de paramétrage.

Le protection isolante (ou capuchon haute tension isolant) 21 a d'une bobine d'allumage à tester est de forme allongée et sensiblement cylindrique, elle comporte un évidement 21 b à une de ses extrémités dans lequel s'étend une partie de la bougie d'allumage lorsqu'elle est montée dans un moteur à combustion interne.

Pour effectuer un test, l'opérateur vient enficher la bobine d'allumage 21 à tester sur la sonde de test 6.

La sonde 6, de forme sensiblement cylindrique et allongée, a un diamètre sensiblement égal à celui d'une bougie d'allumage sur laquelle la bobine 21 vient s'adapter lorsqu'elle est installée sur un moteur à combustion interne. La sonde 6 comporte une coque isolante, une résistance insérée dans cette coque isolante et, à une de ses extrémités une borne conductrice 23 pour assurer la connexion entre la résistance de la sonde et la sortie de l'enroulement secondaire de la bobine 21 à tester. Les dimensions géométriques de cette sonde sont adaptées pour permettre son insertion dans l'évidement 21b de connexion de la bobine et permettre l'établissement d'une liaison électrique entre les éléments internes au boîtier de test 4 et l'enroulement secondaire de la bobine 21 à tester.

L'opérateur doit aussi connecter le primaire de la bobine 21 à tester au boîtier de test en enfichant la fiche électrique 22 dans le connecteur d'alimentation 24 de la bobine à tester. L'opérateur connecte ensuite le boîtier 4 à une source d'alimentation adaptée à fournir une tension de l'ordre de celle fournie par une batterie d'accumulateur de véhicule automobile.

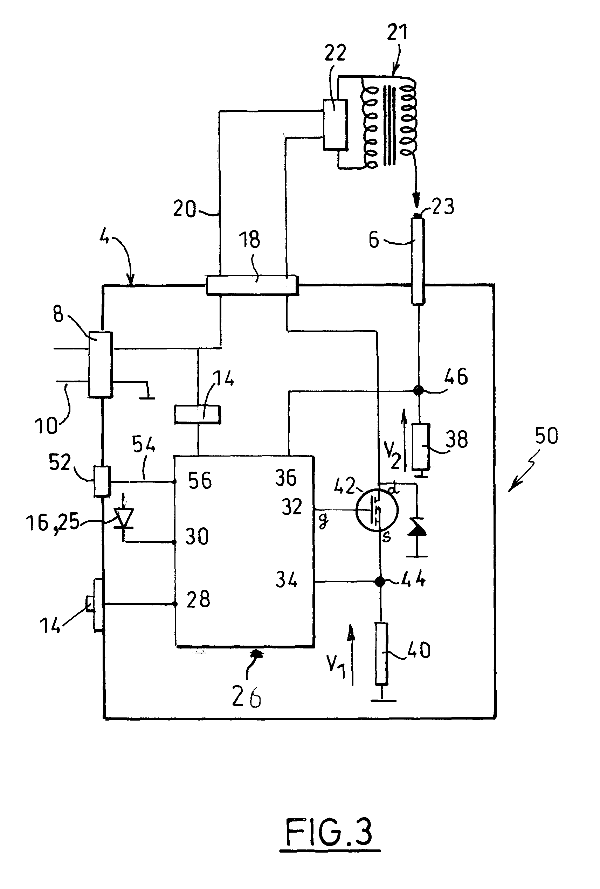

Le schéma électronique de la figure 3 permet de mieux comprendre comment est effectué un test. On a schématisé sur cette figure: le boîtier de tes 4, les différents connecteurs 6, 8 ,18 et 22, les diodes 16 et 25 d'affichages de résultats de test, l'interrupteur de lancement de test 18 ainsi que les câbles d'alimentation 10 et 20.

Le dispositif selon l'invention comporte encore une unité de commande électronique (U.C.E.) 26 dont l'entrée 28 est connectée à l'interrupteur de lancement de test 14. L'entrée 36 de l'U.C.E. 26 est connectée au point milieu d'un pont diviseur de tension composé de la sonde 6 résistive et d'une résistance 38 afin de savoir mesurer une image de la tension générée par le secondaire de la bobine 21 à tester. L'entrée 34 de l'U.C.E. est connectée au noeud 44 entre la source d'un transistor utilisé en tant qu'interrupteur et une résistance 40 connecté à la masse. Cette connexion 44 permet la mesure d'une image du courant traversant le primaire de la bobine.

La sortie 32 de l'U.C.E. est connectée à la grille du transistor 42 et commande l'ouverture et la fermeture du transistor 42 utilisé en tant qu'interrupteur.

La sortie 30 de l'U.C.E. est quant à elle connectée aux afficheur 16 et 25 et commande l'affichage des résultats du test.

Pour débuter un test, l'utilisateur appuie sur le bouton poussoir 14, ce qui provoque une interruption sur l'une des entrées de l'U.C.E. 42. L'U.C.E. provoque alors la fermeture de l'interrupteur commandé 40 et le primaire de la bobine à tester commence alors à se charger. Une tension V1 est mesurée aux bornes de la résistance 40 par l'U.C.E. en tre le noeud 44 et la masse.

Lorsque le courant mesuré atteint une valeur prédéterminée (de l'ordre de 6,5 Ampères), l'U.C.E. commande alors la fermeture de l'interrupteur 40 qui provoque la production d'une forte tension au sein du secondaire de la bobine 21. La tension V2 image de la haute tension générée par la bobine à cet instant est alors mesurée entre le noeud 46 et la masse par l'U.C.E. Les tensions V1 et V2 sont ensuite comparées à des valeurs de seuils U3 et U4 prédéterminés et préprogrammés dans l'U.C.E. qui permettent de conclure sur l'état de fonctionnement de chacun des enroulements primaire et secondaire de la bobine d'allumage 21.

Plus précisément, si le primaire de la bobine n'est pas endommagé, il faut entre 2 et 6 millisecondes pour qu'elle se charge à 6,5 Ampères. Le diagnostic de l'état de fonctionnement du primaire de la bobine se déroule comme suit :
- si le temps de charge du primaire de la bobine dépasse 6 millisecondes pour atteindre 6,5 Ampères, le circuit primaire est considéré comme étant ouvert.
- si le temps de chargement pour atteindre 6,5 Ampères est inférieur à 1 milliseconde, le circuit primaire est considéré comme étant en court-circuit.

En outre si la pente du courant dans la première moitié de la période de charge est trop importante, un court-circuit secondaire est alors diagnostiqué.

Une bobine en état de fonctionnement fournit au secondaire une tension de l'ordre de 30 kilovolts sur une charge de 10 Mégohms. Si la tension V2 est inférieure à un seuil de 28 kilovolts le secondaire de la bobine est considéré comme défaillant.

Les seuils de diagnostiC et les valeurs de temporisation pour les tests sont des variables stockées dans la mémoire de l'U.C.E. pouvant être modifiées grâce à la ligne de communication 54 connectée d'une part à l'entrée/sortie 56 de l'unité électronique de commande et d'autre part au connecteur 52.

L'U.C.E commande ensuite l'affichage du résultat du test sous la forme de l'allumage d'une des D.E.L. 16 et l'affichage d'un message d'erreur sous la forme d'un numéro d'erreur s'affichant grâce à l'afficheur à sept segments 25.

Le message d'erreur permet à l'utilisateur de savoir le type et la localisation de la défaillance (au primaire ou au secondaire par exemple) affectant la bobine d'allumage.

## Revendications

1. Dispositif (50) de diagnostic d'une bobine d'allumage (21), comportant un enroulement primaire et un enroulement secondaire, pour moteur à combustion interne, destiné à la réalisation d'un test de la bobine indépendamment du moteur à combustion interne, le dispositif comportant :
- des moyens de connexion électrique (8,10) dudit dispositif à une source d'alimentation en tension
- des moyens de connexion du dispositif (50) à la bobine (21) à tester,
- des moyens de mesure de grandeurs représentatives de l'état de fonctionnement de la bobine d'allumage à tester,
- des moyens de contrôle et de commande du test
- des moyens de visualisation (16,18) du résultat du diagnostic
**caractérisé en qu'**il comporte une sonde apte à être insérée dans un évidement aménagé dans la partie isolante de la bobine à tester pour d'une part établir un contact électrique entre le secondaire de la bobine à tester et une résistance de la sonde et, d'autre part, maintenir en position la bobine à tester lors d'un test.

2. Dispositif (50) de diagnostic d'une bobine d'allumage (21) pour moteur à combustion interne selon la revendication 1 **caractérisé en ce qu'**il comporte un boîtier de protection (4) de faible encombrement destiné au transport du dispositif.

3. Dispositif de diagnostic d'une bobine d'allumage (21) pour moteur à combustion interne selon la revendication précédente **caractérisé en ce que** la sonde (6) est solidaire du boîtier de protection (4).

4. Dispositif (50) de diagnostic d'une bobine d'allumage (21) pour moteur à combustion interne selon la revendication précédente **caractérisée en ce qu'**une partie de la sonde (6) est externe au boîtier de test (4).

5. Dispositif (50) de diagnostic d'une bobine d'allumage pour moteur à combustion interne selon l'une quelconque des revendications 2 à 4 précédente **caractérisé en ce que** la sonde est de forme sensiblement cylindrique de diamètre proche de celui d'une bougie d'allumage et elle comporte une borne de connexion (23), à son extrémité extérieure au boîtier (4), pour permettre la connexion du secondaire de la bobine (21) à une résistance de la sonde.

6. Dispositif de diagnostic d'une bobine d'allumage selon la revendication précédente **caractérisé en ce qu'**il comporte intégrée au boîtier (4) une unité électronique de commande préprogrammée réalisant successivement :
- la mise sous tension du primaire de la bobine (21),
- la mesure de la valeur d'une tension (V1) représentative du courant traversant le primaire de la bobine,
- la comparaison entre cette valeur mesurée (V1) et au moins une valeur de tension (U3) préenregistrée pour fournir le diagnostic de l'état de fonctionnement de la bobine à tester
- la mesure de la valeur d'une tension représentative (V2) de la haute tension générée par le secondaire de la bobine et,
- la comparaison entre cette valeur mesurée (V2) et une valeur de tension préenregistrée (U4) pour fournir le diagnostic de l'état de fonctionnement de la bobine à tester.

7. Dispositif de diagnostic d'une bobine d'allumage selon la revendication précédente **caractérisé en ce que** l'une des entrées (34) de l'unité électronique de commande (26) est connectée entre la sortie du primaire de la bobine d'allumage (21) à tester et une résistance (40) qui est connectée entre la sortie du primaire et la masse, afin de mesurer la tension (V1) représentative du courant traversant le primaire de la bobine à tester.

8. Dispositif de diagnostic d'une bobine d'allumage selon la revendication précédente **caractérisé en ce qu'**une autre (36) des entrées de l'unité de commande électronique (26) est connectée au point milieu (46) d'un pont diviseur de tension composé de la sonde résistive (6) et d'une résistance (38), le pont diviseur de tension étant lui même connecté au primaire de la bobine (21) pour mesurer la valeur de la tension (V2) représentative de la haute tension générée par le secondaire de la bobine lors du diagnostic.

9. Dispositif selon l'une quelconque des revendications précédentes **caractérisé en ce qu'**il comporte au moins une diode électroluminescente (16) pour l'affichage du ou des résultats du diagnostic de la bobine testée et/ou au moins un afficheur (25) du ou des résultats du diagnostic de la bobine testée.

10. Dispositif selon l'une quelconque des revendications précédentes **caractérisé en ce que** la sonde est résistive.
